Europäisches Patentamt

European Patent Office

Office européen des brevets

(11) Publication number: **0 176 171**
**A1**

## (12) EUROPEAN PATENT APPLICATION

(21) Application number: **85304077.2**

(22) Date of filing: **10.06.85**

(51) Int. Cl.⁴: **G 01 R 15/10**

(30) Priority: **30.08.84 GB 8421916**

(43) Date of publication of application:
**02.04.86 Bulletin 86/14**

(84) Designated Contracting States:
**CH DE FR GB IT LI NL SE**

(71) Applicant: **THORN EMI Instruments Limited**
**Avocet House Archcliffe Road**
**Dover Kent, CT17 9EN(GB)**

(72) Inventor: **Smithson, Edward**
**120, Church Path Deal**
**Kent(GB)**

(74) Representative: **Marsh, Robin Geoffrey et al,**
**Thorn EMI Patents Limited The Quadrangle Westmount**
**Centre Uxbridge Road**
**Hayes Middlesex, UB4 0HB(GB)**

(54) **Electrical device.**

(57) An electrical device for measuring an analogue parameter including a logging circuit (10) for generating an output voltage related logarithmically to an input current and an auto-zero operational amplifier (20) for driving the corresponding input voltage, effective across its input terminals towards zero volts. Input voltages within a relatively wide range of values are accommodated without adversely affecting measurement of the input current; this obviates the need for range switching. By suitable choice of an input resistor (R') and/or current shunt R it is possible to measure an input voltage and/or current.

FIG.1

: 1 :

## ELECTRICAL DEVICE

This invention relates to an electrical device for measuring an analogue parameter, for example an electrical voltage or current, and it relates especially, although not exclusively, to such a device suitable for use in a hand-held measuring instrument.

In recent years a demand has arisen for compact, light-weight measuring instruments, and especially hand-held measuring instruments. In general, such instruments should be capable of measuring an analogue parameter over a wide range of values; without the need for range switching which, when combined with function switching, can make the instrument complex to operate, as well as expensive to produce. In the case of a voltage measurement, for example, a range from o.1V-1000V may be desirable. Moreover, the measured value should be presented to the user in a readily discernible manner.

It is an object of the present invention to provide an electrical device for measuring an analogue parameter, which is suited for use in a measuring instrument of the kind described hereinbefore.

Accordingly there is provided an electrical device for measuring an analogue parameter, the device comprising an electrical circuit for operating on an input current, representing said parameter, to generate an output voltage, related logarithmically to the input current,

characterised by provision of an auto-zero operational amplifier for driving the electrical input voltage, corresponding to said electrical input current and effective across the input terminals of the amplifier, towards zero volts.

With an auto-zero operational amplifier operating in this manner it is possible to accommodate input voltages spanning a relatively wide range of values, thereby obviating the necessity for range switching.

Moreover, components of which the device is comprised may conveniently be in the form of integrated circuits; as such the device may have a compact, light-weight construction suitable for use in a hand-held measuring instrument.

The output voltage may be displayed on an analogue meter; alternatively a digital display means could be used. In these circumstances, the device may include an analogue-to-digital conversion circuit for operating on said logarithmic output voltage thereby to generate a digital signal, and display means arranged to respond to said digital signal to generate a visual representation of the analogue parameter.

Conveniently, the display means may comprise a liquid crystal display (LCD) in the form of a bar graph, for example, although alternative forms of display - a linear array of light emitting diodes, for example, could be used.

In order that the invention may be carried readily into effect a specific embodiment thereof is now described, by way of example only, by reference to the accompanying drawings of which,

Figure 1 shows a circuit diagram of an electrical device according to the invention, and

Figures 2a, b and c show three different forms of display which can be generated by a device in accordance with the invention.

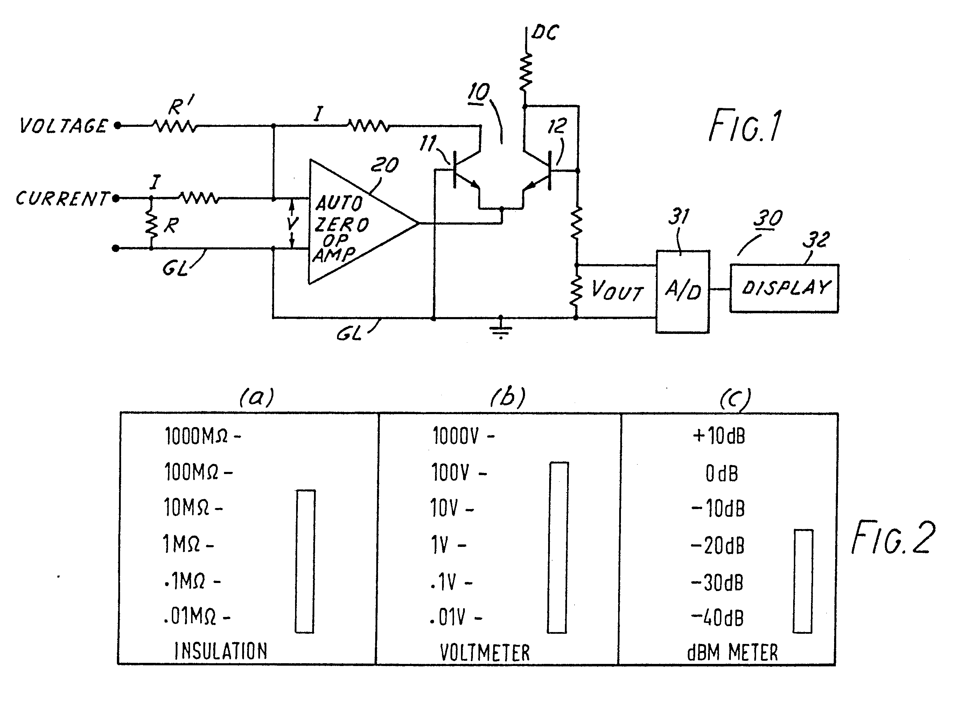

The device shown in Figure 1 can be used to measure an input voltage or an input current, as desired.

The device comprises a logging circuit, shown generally at 10, including a pair of transistors 11 and 12, and an auto-zero operational amplifier 20, the output of which is connected commonly to the emitters of both transistors. In this example, an auto-zero operational amplifier in the form of ICL 7650 Chopper Stabilized Operational Amplifier was used.

An input current, I, is routed to the collector of transistor 11, the base of which is connected to a common voltage line CL, and the auto-zero operational amplifier acts to drive a corresponding input voltage, V, developed across a current shunt R and effective across the input terminals of the amplifier, substantially to zero volts - in practice, to an offset voltage of less than only 1 $\mu$V.

An output voltage $V_{OUT}$ generated between the base of transistor 12 and the common voltage line CL represents a difference between the base and emitter voltages of both transistors, and is related logarithmically to the input current I. In this example, the output voltage $V_{OUT}$ is related logarithmically to the ratio of the input current I. and a reference current comprising the collected current of transistor 12. Transistor 12 is used, in effect, to set a reference voltage defining a zero level in the logarithmic output voltage; moreover, since the transistors are connected together in opposition the output voltage is substantially independent of temperature drift.

It will be understood that with an auto-zero operational amplifier, used in the above-described manner, it becomes feasible to accommodate input voltages within a relatively wide range of values without adversely influencing the measurement of input current, thereby obviating the need for range switching.

For example, assuming input voltages in the range from 200 mV to 10 $\mu$V and a current shunt of 20 m$\Omega$, input currents in the range from 10A to 0.5 mA may be measured reliably on the same logarithmic scale.

The circuit can alternatively be used to measure an input voltage. In this mode of operation an input resistor R' is used to translate the input voltage into an input current for supply to transistor 11 and, as before, the auto-zero operational amplifier acts to drive the input voltage, effective across its input terminals, substantially to zero volts.

It will be appreciated that the device described by reference to Figure 1 may be adapted readily for measurement of a different analogue parameter, for example electrical resistance.

The logarithmic output voltage $V_{OUT}$ may be displayed using a suitably calibrated analogue meter movement, although alternatively a digital display may be preferred.

In the case of a digital display a circuit of the form shown generally at 30 may be provided.

An analogue-to-digital conversion circuit 31 operates on the logarithmic output voltage $V_{OUT}$ to produce a corresponding digital signal and a suitably calibrated display 32, in the form of a LCD bar graph, is driven by the digital signals to generate, on a logarithmic scale, a visual representation of the analogue parameter which is being measured. Three such displays are illustrated, by way of example, in Figures 2a, b and c.

Suitable drive circuits (not shown) are provided to respond to the digital signal and drive the display accordingly. The analogue-to-digital conversion circuit 31 and the drive circuits may comprise discrete components or, more conveniently, they may form part of the same integrated circuit.

Alternatively a display in the form of an array of light emitting diodes could be used.

It will be appreciated that although a device in accordance with the present invention is intended primarily for use in a hand-held measuring instrument, the device may also find application in other forms of measuring instrument.

## CLAIMS

**0176171**

1. An electrical device for measuring an analogue parameter, the device comprising an electrical circuit (10) for operating on an input current, representing said parameter, to generate an output voltage, related logarithmically to the input current,

characterised by provision of an auto-zero operational amplifier (20) for driving the electrical input voltage, corresponding to said electrical input current and effective across the input terminals of the amplifier, towards zero volts.

2. An electrical device according to Claim 1 including an analogue-to-digital conversion circuit (31) for operating on the output voltage thereby to generate a digital signal,

and display means (32) arranged to respond to said digital signal to generate a visual representation of the analogue parameter.

3. An electrical device according to Claim 2 wherein the display means (32) includes a liquid crystal display.

4. An electrical device according to Claim 3 wherein said liquid crystal display is in the form of a bar graph.

5. An electrical device according to Claim 1 including analogue display means responsive to said output voltage to generate a visual representation of said analogue parameter.

6. An electrical device according to any one of Claims 1 to 5 for measuring an electrical voltage and/or current and including respectively an input resistor (R') and/or current shunt (R).

FIG.1

FIG.2

| (a) | (b) | (c) |
|---|---|---|
| 1000MΩ – | 1000V – | +10dB |
| 100MΩ – | 100V – | 0dB |
| 10MΩ – | 10V – | –10dB |
| 1MΩ – | 1V – | –20dB |
| .1MΩ – | .1V – | –30dB |
| .01MΩ – | .01V – | –40dB |
| INSULATION | VOLTMETER | dBM METER |

European Patent Office

**EUROPEAN SEARCH REPORT**

| | DOCUMENTS CONSIDERED TO BE RELEVANT | | EP 85304077.2 |
|---|---|---|---|

| Category | Citation of document with indication, where appropriate, of relevant passages | Relevant to claim | CLASSIFICATION OF THE APPLICATION (Int. Cl.4) |
|---|---|---|---|
| X | DD - A - 87 870 (SCHNEIDER) | 1,5,6 | G 01 R 15/10 |
| A | * Fig. * | 2-4 | |
| | ---- | | |

TECHNICAL FIELDS
SEARCHED (Int. Cl 4)

G 01 R 1/00
G 01 R 15/00
G 04 C 23/00

The present search report has been drawn up for all claims

| Place of search | Date of completion of the search | Examiner |
|---|---|---|
| VIENNA | 30-12-1985 | KUNZE |